Europäisches Patentamt

European Patent Office

Office européen des brevets

(11) Numéro de publication : **0 414 328 B1**

(12) **FASCICULE DE BREVET EUROPEEN**

(45) Date de publication du fascicule du brevet :
04.01.95 Bulletin 95/01

(21) Numéro de dépôt : **90202260.7**

(22) Date de dépôt : **22.08.90**

(51) Int. Cl.⁶ : **H03F 1/56,** H03F 3/45

(54) **Amplificateur différentiel à couplage capacitif.**

(30) Priorité : **25.08.89 FR 8911241**

(43) Date de publication de la demande :
**27.02.91 Bulletin 91/09**

(45) Mention de la délivrance du brevet :
**04.01.95 Bulletin 95/01**

(84) Etats contractants désignés :
**DE FR GB IT**

(56) Documents cités :
**US-A- 3 533 002
US-A- 3 843 934
US-A- 4 667 166
PATENT ABSTRACTS OF JAPAN vol. 5, no.
109 (E-65)(781) 15 juillet 1981; & JP-A-5648704
PATENT ABSTRACTS OF JAPAN vol. 10, no.
158 (E-409)(2214) 06 juin 1986; & JP-A-6112110**

(73) Titulaire : **PHILIPS COMPOSANTS
4, rue du Port aux Vins
F-92150 Suresnes (FR)**
㊴ **FR**
Titulaire : **Philips Electronics N.V.
Groenewoudseweg 1
NL-5621 BA Eindhoven (NL)**
㊴ **DE GB IT**

(72) Inventeur : **Chevallier, Gilles
Société Civile S.P.I.D.,
156 Boulevard Haussmann
F-75008 Paris (FR)**

(74) Mandataire : **Charpail, François et al
Société Civile S.P.I.D.
156, Boulevard Haussmann
F-75008 Paris (FR)**

EP 0 414 328 B1

## Description

La présente invention a pour objet un amplificateur comprenant un étage différentiel présentant une première et une deuxième entrées ainsi qu'une première et une deuxième sortie, la première et la deuxième entrée étant reliées à travers un premier et un deuxième condensateur à respectivement une première et une deuxième bornes d'entrée, par exemple destinées à être connectées à un générateur de courant équivalent à une source de courant en parallèle de laquelle est disposée une impédance, ainsi qu'une première et une deuxième sortie et comportant également une première et une deuxième résistance de contre-réaction.

Un tel amplificateur a déjà été décrit dans la demande de brevet français 88 15958 déposée le 6 décembre 1988 par la Demanderesse. Dans cette demande, la sortie de l'étage qui attaque l'amplificateur se comporte une source de courant Io de fréquence donnée, en parallèle de laquelle est diposé un filtre self-capacité parallèle Lo, Co. Deux condensateurs C et C' disposés en série sur chacune des entrées de l'amplificateur permettent d'éliminer les composantes continues sans perturber le filtrage et d'obtenir une faible partie réactive à l'entrée de l'amplificateur.

La valeur des condensateurs C et C' dépend de la valeur de l'impédance en parallèle avec la source de courant $I_0$. Dans le cas d'un filtre, une valeur trop faible perturbe celui-ci. Dans le cas d'une impédance résistive, une valeur trop faible induit un couplage en courant insuffisant.

L'invention a pour objet un couplage capacitif permettant d'éliminer les composantes continues, mais qui est moins critique quant à sa mise en oeuvre par rapport à la valeur de l'impédance en parallèle avec la source de courant $I_0$.

Dans ce but l'amplificateur est réalisé selon la partie caractérisante de la revendication 1.

Un amplificateur selon l'invention est en particulier susceptible de présenter une transimpédance globale, c'est-à-dire le rapport entre sa tension de sortie $V_s$ et l'intensité $I_O$ de la source de courant, qui dépend moins de l'impédance $Z_s$ de la source de courant que selon l'art antérieur.

Selon un mode de réalisation, l'amplificateur comporte un cinquième et un sixième transistor dont les bases sont connectées au collecteur respectivement des troisième et quatrième transistors, dont les émetteurs qui constituent lesdites première et deuxième sortie de l'amplificateur sont connectés auxdites première et deuxième résistance de contre-réaction et dont les collecteurs sont polarisés par rapport à ladite borne de tension de référence.

Afin de compenser au moins partiellement les décalages de niveau d'entrée, une sixième résistance peut être disposée entre d'une part le point commun à la première résistance et au troisième condensateur et d'autre part la base du premier transistor, et une septième résistance entre d'une part le point commun à la deuxième résistance et au quatrième condensateur et d'autre part la base du deuxième transistor.

Selon un mode de réalisation préféré, la valeur de chacun des premier, deuxième, troisième et quatrième condensateurs est telle que l'impédance différentielle d'entrée et de contre-réaction de l'amplificateur ont une partie réactive qui n'excède pas 15% de l'impédance dans toute la gamme de fréquences de fonctionnement de l'amplificateur.

L'invention sera mieux comprise à la lecture de la description qui va suivre, donnée à titre d'exemple non limitatif, en liaison avec les dessins qui représentent :

- la figure 1, un schéma d'un amplificateur selon l'invention ;
- les figures 2a et 2b respectivement un schéma équivalent du circuit décrit dans la demande précitée, et un schéma illustrant le problème qui se pose dans le cas de l'invention ;
- la figure 3, un schéma correspondant à la présente invention ;
- et la figure 4, un mode de réalisation préféré d'un amplificateur selon l'invention.

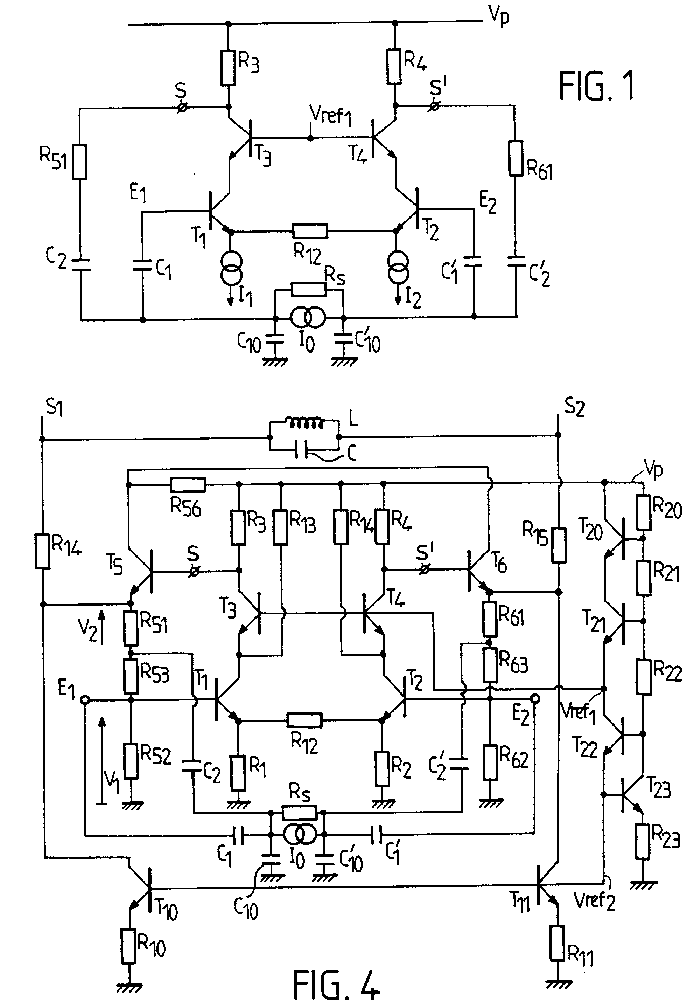

Selon la figure 1, deux transistors $T_1$ et $T_2$ dont les émetteurs sont reliés par une résistance $R_{12}$ forment une paire différentielle, la base des transistors $T_1$ et $T_2$, constituant des entrées respectivement $E_1$ et $E_2$ de l'amplificateur. Deux sources de courant $I_1$ et $I_2$ sont connectées aux émetteurs respectivement de $T_1$ et $T_2$. La résistance $R_{12}$ a une fonction d'amélioration de la linéarité de l'étage différentiel.

Deux transistors $T_3$ et $T_4$ qui peuvent être de plus petites dimensions, sur un circuit intégré, que les transistors $T_1$ et $T_2$, forment avec ceux-ci un montage cascode. Leurs bases sont interconnectées et portées à un potentiel de référence Vref1. Leurs collecteurs sont reliés à une source de tension d'alimentation $V_p$ à travers des résistances respectivement $R_3$ et $R_4$, et leurs émetteurs sont connectés aux collecteurs respectivement des transistors $T_1$ et $T_2$.

Le gain A de l'amplificateur a pour valeur théorique:

$$A = \frac{R_3 + R_4}{R_{12}}$$

Les entrées $E_1$, $E_2$ de l'amplificateur sont connectées à la sortie d'un étage fonctionnant en source de courant et présentant une impédance essentiellement non selfique figurée par la résistance $R_s$ et deux condensateurs $C_{10}$ et $C'_{10}$ qui correspondent par exemple à des capacités parasites. La source de courant Io est connectée aux entrées $E_1$ et $E_2$ à travers des condensateurs $C_1$ et $C'_1$ et aux résistances de contre-réaction à travers des condensateurs $C_2$ et $C'_2$.

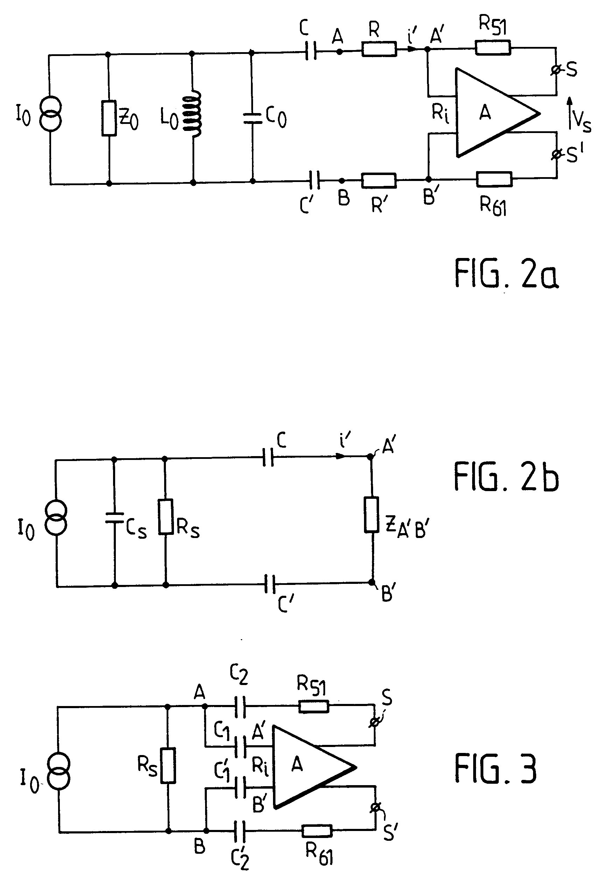

Ainsi qu'il sera maintenant montré en se rapportant aux figures 2a, 2b et 3, ce double couplage capacitif permet d'améliorer le transfert du courant Io à l'amplificateur à transimpédance.

La figure 2a illustre le cas du circuit décrit dans la demande de brevet n°88 15958 précitée. Dans un cas, la source de courant Io présentant une impédance intrinsèque Zo est associée à un circuit résonnant parallèle Lo, Co (par exemple, étage de sortie d'un mélangeur). Le couplage avec les entrées de l'étage différentiel (représenté par un amplificateur A d'impédance d'entrée Ri contre-réactionné par les résistances $R_{51}$ et $R_{61}$) est assuré par deux circuits série comprenant chacun une résistance et un condensateur respectivement R,C et R',C'. (par exemple C = C' = 25pF).

A la résonance, à la condition que Zo soit très supérieur à $Z_{AB}$, $Z_{AB}$ étant l'impédance différentielle prise entre les points A et B, on a i' = Io.

Dans le cas de la figure 2b, il n'y a plus de circuit résonnant, et la source présente en parallèle une capacité différentielle Cs et une résistance Rs avec :

$$\frac{1}{Cs} = \frac{1}{C_{10}} + \frac{1}{C'_{10}}$$

Le couplage s'effectue par hypothèse en mettant en oeuvre la solution connue à savoir à l'aide de condensateurs série C et C' à travers lesquels la source de courant Io voit l'impédance différentielle $Z_{A'B'}$. Le courant i' qui rentre dans l'amplificateur dépend directement de la valeur des capacités C et C'.

On a alors :

$$\frac{i'}{Io} = \frac{Z_s + Z_{A'B'}}{Z_s + Z_{A'B'} + \dfrac{1}{jC\omega} + \dfrac{1}{jC'\omega}}$$

avec :

$$Z_s = \frac{R_s}{1 + jR_sC_s}$$

$R_s$ est une résistance différentielle correspondant par exemple à la somme des valeurs de résistances de polarisation des collecteurs de transistors de l'étage précédent. Pour une valeur de 800$\Omega$ de chacune des résistances, on a $R_s$ = 1600$\Omega$.

En pratique, la valeur de $R_s$ est nettement inférieur à Zo(fig.2a) (par ex : Zo = 40k$\Omega$).

Pour rendre le rapport $\dfrac{i}{Io}$ aussi proche que possible de 1, il faut minorer les termes $Z_{A'B'}$ et les deux termes capacitifs.

Diminuer le terme $Z_{A'B'}$ revient à augmenter la valeur du gain en tension de l'amplificateur A.

En première approximation, on a :

$$Z_{A'B'} \approx \frac{R_{61} + R_{61}}{A + 1}$$

Le terme $Z_{A'B'}$ peut être diminué en adoptant pour A la valeur maximale compatible avec une linéarité acceptable et une stabilité correcte. En général $Z_{A'B'}$ est notablement inférieur à $Z_s$ (en module) et influe peu.

La diminution de la valeur des deux termes capacitifs oblige à augmenter la valeur des capacités ce qui est un inconvénient important en particulier pour un circuit intégré en raison de la surface importante qu'elles nécessitent.

Calculons (fig.2b) la valeur des condensateurs C et C' de manière à transmettre le courant $i_o$ avec une perte suffisamment faible pour être négligée.

On considère en première approximation que $C_s$ n'intervient pas.

On a :

$$\frac{i'}{I_o} = \frac{R'_s}{R'_s + \dfrac{1}{jC\omega} + \dfrac{1}{jC'\omega}} \quad \text{avec } R'_s = R_s + Z_{A'B'}$$

Dans l'amplificateur à transimpédance (de valeur $Z_{21}$), ceci se traduit par une perte sur la tension de sortie $V_s$ (tension de sortie obtenue si on suppose que l'on supprime les condensateurs de couplage) qui devient $V'_s < V_s$, $V'_s$ étant la tension de sortie obtenue pour un même courant que précédemment, mais en présence des condensateurs C et C'). On a :

$$\frac{V'_s}{V_s} = \frac{i'}{I_o} \qquad Z_{21} = \frac{-\alpha R_f}{1 + \alpha} \text{ avec } \alpha = \frac{A R_i}{R_i + R_f} \text{ et } R_f = 2R_{61} = 2R_{61}$$

3

La transimpédance $Z_{21}$ vaut $-R_f$ à condition que

$$\alpha = \frac{A R_i}{R_i + R_f}$$

soit très supérieur à l'unité.

Pour un rapport k donné entre l'impédance réactive et l'impédance résistive, on a :

$$\frac{V'_s}{V_s} = \frac{R_s}{\sqrt{R_s + \dfrac{4}{C^2\omega^2}}} = \frac{1}{\sqrt{1 + |k^2|}}$$

avec

$$k = \frac{2}{jR'_s C\omega} \text{ et si } C = C'.$$

La valeur de $R_s$ a toujours une influence sur la valeur de la transimpédance et il faut donc concevoir le couplage capacitif en fonction de la valeur spécifiée de $R_s$.

Selon l'invention (fig.3), au lieu du couplage capacitif série (condensateurs C et C'), on réalise un couplage direct et on introduit dans l'amplificateur des condensateurs $C_1$, $C_2$ d'une part, et $C_2$ et $C'_2$ d'autre part.

Les condensateurs $C_1$ et $C'_1$ sont disposés entre la source de courant $I_o$ et les entrées $E_1$ et $E_2$ de l'amplificateur, mais en aval des points A' et B' de retour de la contre-réaction. Les condensateurs $C_2$ et $C'_2$ sont disposés dans le circuit de contre-réaction de l'amplificateur en série avec les résistances respectivement $R_{51}$ et $R_{61}$ soit $R_f = 2R_{51} = 2R_{61}$. Il ne sont alors plus traversés par une partie du courant $I_0$.

Par contre les condensateurs $C_1$, $C'_1$, $C_2$ et $C'_2$, du fait qu'ils sont disposés dans la boucle de contre-réaction, inlfuent sur la tension de sortie $V_s$.

La transimpédance intrinsèque $Z'_{21}$ de l'amplificateur a pour valeur :

$$Z'_{21} = \frac{-(R_f + \dfrac{2}{jC_2\omega})\,\alpha}{1 + \alpha}$$

avec

$$\alpha = \frac{A(R_i + \dfrac{2}{jC_1\omega})}{R_i + \dfrac{2}{jC_1\omega} + R_f + \dfrac{2}{jC_2\omega}}$$

Si on pose

$$k' = \frac{2}{jR_iC_1\omega} = \frac{2}{jR_fC_2\omega}$$

la formule donnant $\alpha$ se simplifie et on a :

$$\alpha = \frac{A Ri}{Ri + R_f}$$

$\alpha$ a la même valeur que dans le cas précédent à condition que le rapport k' soit le même pour $C_1$, $C'_1$ et $C_2$, $C'_2$.

et on a :

$$Z'_{21} = -(R_f + \frac{2}{jC_2\omega}) = -R_f(1 + k')$$

$$\frac{V'_s}{V_s} = \frac{1}{1 + k'} \text{ soit } \frac{V'_s}{V_s} = \frac{1}{\sqrt{1 + |k'^2|}}$$

Pour k = k', on obtient le même résultat que dans le cas précédent (fig.3), c'est à dire que la contribution des condensateurs à la diminution de la valeur de la tension de sortie est la même que précédemment.

La transimpédance totale $Z'_{21_t}$ a pour valeur :

$$Z'_{21t} = \frac{-R_f\alpha_t}{1 + \alpha_t} \text{ avec } \alpha_t = \frac{A R_i R_s}{R_i R_s + R_s R_f + R_i R_f}$$

Si $\alpha_t \gg 1$, alors on a $Z'_{21t} \simeq Z'_{21} = -R_f$
et tant que $\alpha_t \gg 1$, la valeur de $R_s$ n'influe pas sur la transimpédance.

Il en résulte qu'un amplificateur peut être conçu qui fonctionne dans une large gamme de valeurs de $R_s$ à résultat identique tant que $\alpha_t \gg 1$.

On va maintenant montrer que ce résultat est susceptible de conduire à une valeur totale plus faible des capacités.

Dans le cas de la figure 2b, on a en effet :

$$C_t = C + C'$$

$C_t$ = valeur totale des capacités.

d'où

$$C_t = \frac{4}{kR_s\omega}$$

$C_t$ a une valeur d'autant plus élevée que $R_s$ est faible. Dans le cas de la figure 1, on a pour la même valeur de $R_s$

$$C'_t = C'_{t_1} + C'_{t_2}$$

$$C'_{t_1} = \frac{4}{k R_i \omega} \qquad \text{avec } \frac{1}{R_i} = \frac{1}{2R_{52}} + \frac{1}{h R}$$

avec

$$\frac{1}{R} = \frac{1}{R_{12}} + \frac{1}{R_1 + R_2}$$

$R_1$ et $R_2$ étant des résistances constituant les sources de courant $I_1$ et $I_2$.

et

h = gain en courant des transistors.

$$C'_{t_2} = \frac{4}{k R_f \omega}$$

Posons

$$R_f = n_2 R_s$$
$$R_i = n_1 R_s$$

Si on conserve le même rapport k par hypothèse, (pour des performances égales), alors

$$C'_{t_1} = \frac{C_t}{n_1} \qquad C'_{t_2} = \frac{C_t}{n_2}$$

Soit alors :

$$n = \frac{C_t}{C'_t} = \frac{C_t}{\dfrac{C_t}{n_1} + \dfrac{C_t}{n_2}} = \frac{n_1 n_2}{n_1 + n_2}$$

Lorsque n est supérieur à 1, la solution selon l'invention permet en outre de gagner en surface sur la valeur des capacités par rapport au cas de l'art antérieur (à $R_s$ égal). La valeur de n est d'autant plus élevée que $R_s$ est plus faible. En d'autres termes, lorsqu'on la met en oeuvre avec des sources de courant à faible impédance interne, l'invention apporte l'avantage d'une diminution de la surface totale des condensateurs par rapport à la solution de l'art antérieur.

Application numérique :

h = 70

$R_{12}$ = 100Ω

$R_1 = R_2 = 290Ω$

$R_{51} = R_{52} = 15\,k\Omega$

$R_f = 2R_{51} = 2R_{61} = 5840Ω$

$n_1$ = 3,1 $n_2$ = 3,6 n = 1,66

En pratique, le facteur d'amélioration n de la valeur totale des capacités peut être encore plus élevé, car il est possible de mettre en oeuvre un amplificateur dont le terme $\alpha$ est plus élevé que précédemment car la valeur de $R_{51}$ et $R_{52}$ peut être choisie plus élevée sans inconvénient. On obtient donc une valeur plus élevée de la transimpédance en boucle ouverte $\alpha R_f$, qu'il est acceptable d'abaisser quelque peu en diminuant la valeur des capacités (ce qui augmente la valeur de k).

Il vient alors

$$n = \frac{n_0 n_1 n_2}{n_0 n_1 + n_2}$$

avec $n_0 > 1$ (en pratique de l'ordre de 1,5)

Dans le cas de l'application numérique précédente, on obtient n = 2, pour $n_o$ = 1,5.

La figure 4 représente un mode préféré de réalisation de l'invention, notamment destiné à la réalisation d'un amplificateur de fréquence intermédiaire (FI), et plus particulièrement un amplificateur à transimpédance destiné à amplifier les signaux issus d'un mélangeur de télévision. Dans celui-ci les éléments communs avec la figure 1 (transistors $T_1$ à $T_4$, résistances $R_{12}$, $R_3$ et $R_4$) portent la même référence. Les sources de courant $I_1$ et $I_2$ sont constituées par des résistances respectivement $R_1$ et $R_2$ connectées entre les émetteurs respectivement des transistors $T_1$ et $T_2$ et le pôle de mode commun. Les résistances $R_1$ et $R_2$ contribuent au gain de l'étage, et il faut remplacer dans la formule précédente $R_{12}$ par $R'_{12}$ avec $\dfrac{1}{R'_{12}} = \dfrac{1}{R_{12}} + \dfrac{1}{R_1 + R_2}$. Des sources de courant $I_3$ et $I_4$ éventuellement présentes sont constituées par des résistances respectivement $R_{13}$ et $R_{14}$ connectées entre la source de tension d'alimentation $V_p$ et les collecteurs respectivement des transistors $T_1$ et $T_2$.

Des tensions de référence sont générées de manière classique à partir d'une chaîne de résistances ($R_{20}$, $R_{21}$, $R_{22}$) en série entre la source de tension d'alimentation $V_p$ et une source de courant ($T_{23}$, $R_{23}$), associée à des transistors ($T_{20}$, $T_{21}$, $T_{22}$) dont les trajets collecteur émetteur sont en série et dont les bases sont connectées aux points milieu entre les résistances respectivement $R_{20}$ et $R_{21}$, $R_{21}$ et $R_{22}$, et $R_{22}$ et $R_{23}$. Vref1 est ainsi fournie à l'émetteur de $T_{21}$.

Pour obtenir un amplificateur à transimpédance, on réalise en outre une contre-réaction. Des transistors $T_5$ et $T_6$ (facultatifs) sont montés en émetteur suiveur à partir des collecteurs de transistors respectivement $T_3$ et $T_4$, leur base étant connectée à cet effet au collecteur respectivement des transistors $T_3$ et $T_4$. Les collecteurs des transistors $T_5$ et $T_6$ sont interconnectés et reliés à la sortie de tension d'alimentation $V_p$ à travers une résistance commune $R_{56}$ et leurs émetteurs sont connectés chacun à une source de courant, respectivement ($T_{10}$, $R_{10}$) et ($T_{11}$, $R_{11}$), les transistors $T_{10}$ et $T_{11}$ ayant à cet effet leur base portée à un potentiel de référence Vref2. A cet effet, leurs bases sont connectées à l'émetteur du transistor $T_{22}$, lui-même connecté à la base du transistor $T_{23}$. La contre-réaction est réalisée grâce à d'une part la résistance $R_{51}$ en série avec le condensateur $C_2$, et avec l'émetteur du transistor $T_5$ et d'autre part $R_{61}$ en série avec le condensateur $C'_2$, et avec l'émetteur du transistor $T_6$. Des résistances $R_{52}$ et $R_{62}$ peuvent être en outre disposées entre la base respectivement des transistors $T_1$ et $T_2$ et le pôle de mode commun pour assurer avec $R_{51}$ et $R_{61}$ les décalages de tension.

Pour les entrées, la transimpédance différentielle $Z_{21}$ a alors pour valeur (en supposant $R_{51} = R_{61}$, et $R_{52} = R_{62}$) :

$$Z_{21} = - \frac{2R_{51}\dfrac{R_x A_v}{R_x + 2R_{61}}}{1 + \dfrac{R_x A_v}{R_x + 2R_{51}}} = \frac{-2R_{61}\,\alpha'}{1 + \alpha'}$$

avec

$$\frac{1}{R_x} = \frac{1}{2R_{52}} + \frac{1}{R_s} + \frac{1}{Z_i} \text{ et } \alpha' = \frac{R_x A_v}{R_x + 2R_{51}}$$

avec $Z_1$ = impédance d'entrée de la paire différentielle ($T_1$,$T_2$), et $A_v$ = gain en tension de l'étage différentiel. Tans que $\alpha' \gg 1$, $Z_{21}$ a pour valeur $-2R_{61}$.

$Z_{21}$ étant spécifié et $R_{61}$ étant choisie (c'est elle qui est en effet déterminante), on détermine le courant I traversant les résistances $R_1$ et $R_2$ de manière à assurer la linéarité de l'étage différentiel (par exemple I = 1,5mA)

Si on met en oeuvre les sources de courant $I_3$ et $I_4$ (résistances $R_{13}$ et $R_{14}$) les conditions de fonctionnement sont les suivantes :

$$V_2 > V_3$$
$$V_1 + V_2 + V_{BE5} + R_3 I' < V_p$$

avec :

$V_1 = $ différence de potentiel en statique aux bornes de $R_{62}$

$V_2 = $ différence de potentiel en statique aux bornes de $R_{61}+R_{53}$

$V_3 = $ demi-amplitude maximale du signal de sortie (par exemple, sur l'émetteur du transistor $T_5$)

$I' = $ courant statique à travers les résistances $R_3$ et $R_4$.

$V_{BE5}$ tension base-émetteur des transistors $T_5$ et $T_6$ (0,7V)

Le filtre de l'amplificateur FI est constitué par un circuit parallèle LC connecté entre ses deux sorties $S_1$ et $S_2$. Ces sorties sont reliées aux émetteurs des transistors $T_5$ et $T_6$ à travers des résistances respectivement $R_{14}$ et $R_{15}$.

L'étage précédent (mélangeur) est figuré comme une source de courant $I_0$ en parallèle avec une résistance $R_s$ et deux condensateurs $C_{10}$ et $C'_{10}$ ayant chacun une borne à la masse. La source de courant Io est reliée aux entrées $E_1$ et $E_2$ à travers un condensateur en série respectivement $C1$ et $C'_1$. Les capacités $C_1$ et $C'_1$ étant destinées à être intégrées, il en résulte que leur valeur doit être aussi faible que possible, mais compatible avec une faible partie réactive à l'entrée et en contre-réaction de l'amplificateur.

La source de courant Io est reliée d'une part au montage série de la résistance $R_{51}$ et du condensateur $C_2$ et d'autre part au montage série de la résistance $R_{61}$ et du condensateur $C'_2$. Des résistances $R_{53}$ et $R_{63}$ sont avantageusement disposées en série avec d'une part $R_{51}$ et $R_{62}$ et d'autre part $R_{61}$ et $R_{62}$. Leur valeur est choisie de manière à corriger les éventuels décalages de niveau d'entrée. Celle-ci doit être donc suffisamment faible pour corriger ces décalages, mais suffisamment élevée pour ne pas intervenir dans la contre-réaction de l'amplificateur, c'est-à-dire que $R_{53}$ et $R_{63}$ ont une valeur plusieurs fois supérieure à celle de $R_{51}$ et $R_{61}$.

On a par exemple :

$R_{51} = R_{61} = 3k\Omega$ $R_{53} = R_{63} = 10k\Omega$ $R_{62} = R_{62} = 15k\Omega$

$R_1 = R_2 = 300\Omega$

$R_{12} = 100\Omega$ $R_3 = R_4 = 3k\Omega$ soit A = 70.

En pratique, si on tient compte des composants parasites, le gain est plus faible que la valeur théorique donnée ci-dessus (on a alors $A \approx 40$).

En outre, les résistances $R_{52}$ et $R_{62}$ sont avantageuses, car elles permettent de déterminer les potentiels du point de vue statique. On a :

$$\frac{V_1}{V_1 + V_2} = \frac{R_{62}}{R_{61} + R_{62} + R_{53}} = \frac{R_{62}}{R_{61} + R_{62} + R_{63}}$$

**Revendications**

1. Amplificateur comprenant un étage différentiel présentant une première et une deuxième entrée ainsi qu'une première et une deuxième sortie, la première et la deuxième entrée étant reliées à travers un premier et un deuxième condensateur à respectivement une première et une deuxième bornes d'entrée, ainsi qu'une première et une deuxième sortie et comportant également une première et une deuxième résistance de contre-réaction, caractérisé en ce qu'il comporte un troisième ($C_2$) et un quatrième ($C'_2$) condensateur disposés en série avec respectivement la première ($R_{51}$) et la deuxième ($R_{61}$) résistance de contre-réaction de l'amplificateur, entre la première et la deuxième borne d'entrée et respectivement la première et la deuxième sortie de l'amplificateur.

2. Amplificateur selon la revendication 1 caractérisé en ce que l'étage différentiel est du type cascode et comporte un premier ($T_1$) et un deuxième ($T_2$) transistor dont les émetteurs sont connectés à respectivement une première ($R_1$) et une deuxième ($R_2$) source de courant et sont reliés entre eux par une troisième résistance ($R_{12}$) et dont les collecteurs sont connectés à une charge active constituée par le trajet collecteur-émetteur respectivement d'un troisième ($T_3$) et d'un quatrième ($T_4$) transistor en série avec respectivement une quatrième ($R_3$) et une cinquième ($R_4$) résistance connectées à une borne de tension d'alimentation, les troisième ($T_3$) et quatrième ($T_4$) transistor ayant leur base connectée à une borne de tension de référence ($V_{ref1}$).

3. Amplificateur selon la revendication 2, caractérisé en ce qu'il comporte un cinquième ($T_5$) et un sixième ($T_6$) transistor dont les bases sont connectées au collecteur respectivement des troisième ($T_3$) et quatrième ($T_4$) transistors, dont les émetteurs sont connectés respectivement auxdites première ($R_{61}$) et deuxième ($R_{61}$) résistance de contre-réaction, et dont les collecteurs sont polarisés par rapport à ladite borne de tension de référence.

4. Amplificateur selon une des revendications 2 ou 3 caractérisé en ce qu'il comporte une sixième résistance ($R_{63}$) disposée entre d'une part le point commun à la première résistance ($R_{51}$) et au troisième condensateur ($C_2$) et d'autre part la base du premier transistor ($T_1$) et une septième résistance ($R_{63}$) disposée entre d'une part le point commun à la deuxième résistance ($R_{61}$) et au quatrième condensateur ($C'_2$), et d'autre part à la base du deuxième transistor ($T_2$).

5. Amplificateur selon l'une des revendications précédentes caractérisé en ce que la valeur de chacun des premier, deuxième, troisième et quatrième condensateur est telle que l'impédance différentielle d'entrée de l'amplificateur ait une partie réactive qui n'excède pas 15% de l'impédance dans toute la gamme des fréquences de fonctionnement de l'amplificateur.

6. Amplificateur selon une des revendication 2 à 5 caractérisé en ce qu'il comporte une huitième résistance ($R_{62}$) disposée entre la base du premier transistor ($T_1$) et une deuxième borne de tension d'alimentation, et une neuvième résistance ($R_{62}$) disposée entre la base du deuxième transistor ($T_2$) et ladite deuxième borne de tension d'alimentation.

**Patentansprüche**

1. Verstärker mit einer einen ersten und einen zweiten Eingang sowie einen ersten und einen zweiten Ausgang aufweisenden Differenzstufe, wobei der erste und der zweite Eingang über einen ersten und einen zweiten Kondensator mit einer ersten bzw. einer zweiten Eingangsklemme sowie mit einem ersten und einem zweiten Ausgang verbunden sind, und ferner mit einem ersten und einem zweiten Gegenkopplungswiderstand, dadurch gekennzeichnet, daß der Verstärker einen dritten ($C_2$) und einen vierten $C'_2$) Kondensator umfaßt, der in Reihe mit dem ersten ($R_{51}$) bzw. dem zweiten (R613) Gegenkopplungswiderstand des Verstärkers zwischen die erste und die zweite Eingangsklemme und den ersten bzw. den zweiten Ausgang des Verstärkers zwischengeschaltet ist.

2. Verstärker nach Anspruch 1, dadurch gekennzeichnet, daß die Differenzstufe als Kaskodenschaltung ausgebildet ist und einen ersten ($T_1$) und einen zweiten ($T_2$) Transistor umfaßt, deren Emitter mit einer ersten ($R_1$) bzw. einer zweiten (R2) Spannungsquelle und untereinander über einen dritten Widerstand ($R_{12}$) verbunden sind und deren Kollektoren mit einer Wirklast verbunden sind, bestehend aus dem Kollektor-Emitter-Weg eines dritten ($T_3$) bzw. eines vierten ($T_4$) Transistors, die mit einem vierten ($R_3$) bzw. einem fünften ($R_4$), mit einer Speisespannungsklemme verbundenen Widerstand in Reihe geschaltet sind, wobei die Basen des dritten ($T_3$) und des vierten ($T_4$) Transistors an einer Referenzspannungsklemme ($V_{ref1}$) liegen.

3. Verstärker nach Anspruch 2, dadurch gekennzeichnet, der er einen fünften ($T_5$) und einen sechsten ($T_6$) Transistor umfaßt, deren Basen an den Kollektor des dritten ($T_3$) bzw. des vierten ($T_4$) Transistors angeschlossen, deren Emitter mit dem ersten ($R_{51}$) und zweiten ($R_{61}$) Gegenkopplungs-Widerstand verbunden und deren Kollektoren relativ zu der genannten Referenzspannungsklemme polarisiert sind.

4. Verstärker nach einem der Ansprüche 2 oder 3, dadurch gekennzeichnet, daß er einen sechsten ($R_{53}$) Widerstand, der zwischen dem gemeinsamen Punkt des ersten Widerstandes ($R_{51}$) und des dritten Kondensators ($C_2$) einerseits und der Basis des ersten Transistors ($T_1$) andererseits geschaltet ist, und einen siebter Widerstand ($R_{53}$) umfaßt, der zwischen dem gemeinsamen Punkt des zweiten Widerstandes ($R_{61}$) und des vierten Kondensators ($C'_2$) einerseits und der Basis des zweiten Transistors ($T_2$) andererseits zwischengeschaltet sein.

5. Verstärker nach einem der vorhergehenden Ansprüche, dadurch gekennzeichnet, daß der Wert des ersten, zweiten, dritten und vierten Kondensators jeweils so gewählt ist, daß die Eingangs-Differenzimpedanz des Verstärkers einen reaktiven Anteil aufweist, der 15 % der Impedanz über den gesamten Betriebsfreqzenzbereich des Verstärkers hinweg nicht übersteigt.

6. Verstärker nach einem der Ansprüche 2 bis 5, dadurch gekennzeichnet, daß er einen achten Widerstand ($R_{52}$), der zwischen der Basis des ersten Transistors ($T_1$) und einer zweiten Speisespannungsklemme angeordnet ist, und einen neunten Widerstand ($R_{52}$) aufweist, der zwischen der Basis des zweiten Transistors ($T_2$) und der zweiten Speisespannungsquelle angeordnet ist.

**Claims**

1. An amplifier comprising a differential stage having a first and a second input as well as a first and a second output, the first and the second input being coupled, *via* a first and a second capacitor, to a first and a second input terminal, and also comprising a first and a second output as well as a first and a second feedback resistor, characterised in that it comprises a third ($C_2$) and a fourth ($C'_2$) capacitor arranged in series with, respectively, the first ($R_{51}$) and the second ($R_{61}$) feedback resistor of the amplifier, between the first and the second input terminal and the first and the second output of the amplifier.

2. An amplifier as claimed in Claim 1, characterised in that the differential stage is of the cascode type and comprises a first ($T_1$) and a second ($T_2$) transistor whose emitters are connected to a first ($R_1$) and a second ($R_2$) current source, respectively, and coupled to each other by a third resistor ($R_{12}$), and whose collectors are connected to an active load constituted by the collector-emitter path of a third ($T_3$) and a fourth ($T_4$) transistor, respectively, in series with a fourth ($R_3$) and a fifth ($R_4$) resistor, respectively, connected to a supply voltage terminal, the third ($T_3$) and the fourth ($T_4$) transistor having their bases connected to a reference voltage terminal ($V_{ref1}$).

3. An amplifier as claimed in Claim 2, characterised in that it comprises a fifth ($T_5$) and a sixth ($T_6$) transistor having their bases connected to the collectors of the third ($T_3$) and the fourth ($T_4$) transistor, respectively, having their emitters connected to said first ($R_{51}$) and second ($R_{61}$) feedback resistors, and having their collectors biassed with respect to said reference voltage terminal.

4. An amplifier as claimed in Claim 2 or 3, characterised in that it comprises a sixth resistor ($R_{53}$) arranged between, on the one hand, the node between the first resistor ($R_{51}$) and the third capacitor ($C_2$) and, on the other hand, the base of the first transistor ($T_1$) and a seventh resistor ($R_{63}$) arranged between, on the one hand, the node between the second resistor ($R_{61}$) and the fourth capacitor ($C'2$) and, on the other hand, the base of the second transistor ($T_2$).

5. An amplifier as claimed in any one of the preceding Claims, characterised in that the value of each of the first, second, third and fourth capacitors is such that the differential input impedance of the amplifier has a reactive component which does is not larger than 15% of the impedance in the entire range of operating frequencies of the amplifier.

6. An amplifier as claimed in any one of the Claims 2 to 5, characterised in that it comprises an eighth resistor ($R_{62}$) arranged between the base of the first transistor ($T_1$) and second supply voltage terminal, and a ninth resistor ($R_{62}$) arranged between the base of the second transistor ($T_2$) and said second supply voltage terminal.

FIG. 1

FIG. 4

FIG. 2a

FIG. 2b

FIG. 3